(19) Europäisches Patentamt / European Patent Office / Office européen des brevets

(11) **EP 2 894 734 A1**

(12) **EUROPEAN PATENT APPLICATION**

(43) Date of publication:
**15.07.2015 Bulletin 2015/29**

(21) Application number: **14305050.8**

(22) Date of filing: **14.01.2014**

(51) Int Cl.:
*H01S 5/0625* (2006.01)　　*H01S 5/40* (2006.01)
*H01S 5/026* (2006.01)　　*G02B 6/12* (2006.01)
*H04J 14/02* (2006.01)　　*H04B 10/50* (2013.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ALCATEL LUCENT**
**92100 Boulogne-Billancourt (FR)**

(72) Inventors:
• **Debregeas-Sillard, Hélène**
**Murray Hill, NJ New Jersey 07974-0636 (US)**
• **Chimot, Nicolas**
**91460 Marcoussis (FR)**

(74) Representative: **Loyer & Abello**
**9, rue Anatole de la Forge**
**75017 Paris (FR)**

(54) **Tunable laser device**

(57)　A photonic integrated circuit PIC (16) comprising a semiconductor substrate layer and a plurality of tunable Distributed Feedback lasers (1, 100, 401), wherein each DFB laser of the PIC has a phase section in passive material longitudinally located between Bragg sections in active material, wherein the tuning device of each DFB laser includes an electrode (15) arranged on the phase section, the electrode being connected to an electrical source for applying an electrical signal to the phase section, the electrode being able to inject current in the phase section of the DFB laser to tune the emission wavelength of said DFB laser, and wherein the current injection by the electrode in the phase section causes an optical path variation in the phase section and wherein the amplitude of the optical path variation in the phase section is equal to or greater than the optical path of one grating pitch of the Bragg grating.

FIG.4

## Description

### Field of the invention

The invention relates to the field of emission devices used in optical communications, especially to the field of photonic integrated circuits, hereafter named PIC. A PIC includes several optoelectronic devices on the same semiconductor substrate.

### Background

WDM consists in combining the plurality of signals of the lasers at different wavelengths in a single optical fiber. According to this method, the global flow rate of the optical fiber is the sum of the flow rates of all the signals. A Wavelength Division Multiplexed (WDM) source comprises an array of lasers, emitting on different wavelengths, and possibly independently modulated.

The emission wavelength of each laser must be controlled precisely e.g on standardized International Telecommunication Union (ITU grid) wavelengths, in emission and in reception, to avoid signal interferences. An uncontrolled wavelength of the emission of a signal may cause said signal to flow at the same wavelength as another signal in the same optical fiber, causing the quality of both signals to decline. Such interference is also called a spectral collision. The reception of an uncontrolled signal by a receiver device may also cause a degradation of the quality of both signals or even the detection of another signal than the one which was intended to said receiver device.

Accordingly, the lasers are initially designed to emit on the desired wavelengths with the best possible accuracy (typically ±0.3nm) by an accurate setting of the Bragg grating pitch. But a simple and low power consuming mechanism is needed on each laser to independently and finely tune exactly on the desired wavelength, and to keep the laser locked on this wavelength along the device lifetime.

### Summary

In an embodiment, the invention provides a photonic integrated circuit PIC comprising a semiconductor substrate layer and a plurality of Distributed FeedBack lasers, hereafter named DFB lasers, arranged on the semiconductor substrate layer, each DFB laser having a tuning device able to tune its output wavelength, wherein each DFB laser of the PIC has a phase section in passive material longitudinally located between Bragg sections in active material, each Bragg section comprising a waveguide in the form of an elongate strip and a Bragg grating including a plurality of grating teeth mutually spaced by a grating pitch that extends along a longitudinal direction of the Bragg sections, and wherein the tuning device of each DFB laser includes an electrode arranged on the phase section of said DFB laser, the electrode being connected to an electrical source for applying an electrical signal to the phase section, the electrode being able to inject current in the phase section of the DFB laser to tune the emission wavelength of said DFB laser, and wherein the current injection by the electrode in the phase section causes an optical path variation in the phase section and wherein the amplitude of the optical path variation in the phase section is at least equal to or greater than the optical path of one grating pitch of the Bragg grating.

According to embodiments, such tunable laser device may comprise one or more of the features below.

In an embodiment, the photonic integrated circuits further includes a multiplexer having a plurality of inputs wherein each DFB laser of the plurality of DFB lasers of the PIC has an optical output which is connected to a respective input of the multiplexer.

In an embodiment, the variation of the effective index of the phase section times the length of the phase section in the at least one DFB laser is at least equal to the effective index of the Bragg grating section times the grating pitch in the Bragg grating of the at least one DFB laser.

In an embodiment, the photonic integrated circuit further includes a plurality of modulators, wherein each modulator is connected to one DFB laser to receive a DFB laser output signal to modulate.

In an embodiment, the photonic integrated circuit further includes a plurality of photodiodes, and wherein each photodiode is located at an end of a DFB laser.

In an embodiment, the plurality of photodiodes are in the same material than the Bragg sections with a reverse bias.

The invention also provides an optical communication terminal including a photonic integrated circuit as described here above.

The invention originates from the observation of the need to precisely control the emitting wavelength of each laser in an optical fiber transmission system.

An idea on which the invention is based on is to provide a PIC wherein each laser may be independently tuned on the selected wavelength with a simple and low-consumption mechanism.

Another aspect of the invention is to propose a PIC including a plurality of tunable lasers which operate at low temperatures and have good performances and reliability. An aspect of the invention is to propose a PIC including a plurality of tunable lasers without locally increasing temperature of the lasers. An aspect of the invention is to propose a PIC including a plurality of tunable lasers without thermal crosstalk. An aspect of the invention is to provide a PIC including a plurality of tunable lasers in which lasers wavelength controls are independent.

Another aspect of the invention is to propose a PIC including a plurality of tunable lasers wherein, whatever the initial phase condition is, any wavelength can be selected within the tuning range. An aspect of the invention is to propose a PIC including a plurality of tunable lasers with low variation of output power. Another aspect of the invention is to propose a PIC including a plurality of tunable lasers having low power variation with tuning. An aspect of the invention is to propose a PIC including a plurality of tunable lasers having low power consumption.

**Brief description of the drawings**

These and other aspects of the invention will be apparent from and elucidated with reference to the embodiments described hereinafter, by way of example, with reference to the drawings.

- Figure 1 represents a cross section of a tunable Distributed FeedBack laser having a central section made of passive material between two active Bragg sections;
- Figure 2 illustrates schematically a three sections tunable laser with a Fabry-Perot Pseudo-cavity, seen from above;
- Figure 3 is a schematic representation of wavelength tuning in the DFB laser of Fig 1B;
- Figure 4 illustrates a schematic representation of a photonic integrated circuit including a plurality of DFB lasers;
- Figure 5 is a graphical representation of the tuning range and the Side Mode Suppression Ratio according to the current injected in the phase section, in a DFB laser of the PIC of figure 4;
- Figure 6 illustrates a schematic representation of an embodiment of a photonic integrated circuit including a plurality of DFB lasers, a plurality of photodiodes behind the DFB lasers, and a plurality of modulators.

**Detailed description of the embodiments**

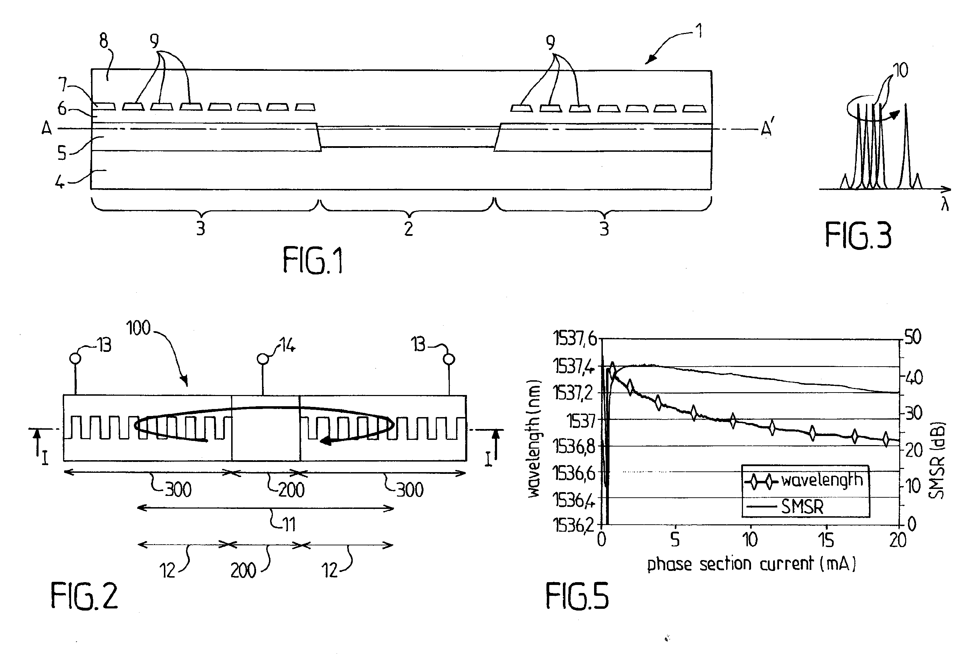

Figure 1 illustrates an embodiment of a multi-section Distributed FeedBack laser (DFB laser) 1 in cross section. The DFB laser 1 has a central section 2, hereafter named phase section 2. The phase section 2 is located, along a longitudinal axis AA' of the DFB laser 1, between two Bragg sections 3. The phase section 2 is made of a passive material. The Bragg sections 3 are made of an active material. Current injection in the Bragg sections 3 generates optical output power. Current injection in the phase section 2 allows wavelength tuning.

The Bragg sections 3 of the DFB laser 1 include, superposed from a bottom layer to a top layer, a substrate layer 4, an active layer 5, a spacer layer 6, a grating layer 7 and a burying layer 8. The grating layer 7 consists in a plurality of teeth 9 regularly spaced according to a grating pitch along the longitudinal axis AA'. Typically, the grating layer 7 forms a Bragg grating in the Bragg sections 3.

The substrate layer 4 is for instance InP. The active layer 5 is for instance made of a stack of layers, for instance using multi-quantum wells of InGaAsP or InGaAlAs separated by InGaAsP barriers with higher bandgap. The spacer layer 6 may be made of any suitable material, for instance the same material as the substrate layer 4, i.e. an InP layer. The material used for the grating layer 7 is selected according to the wavelength which has to be reflected by it, corresponding to the wavelength of emission of the DFB laser 1 in use. Typically, the grating layer 7 is transparent to the selected wavelengths. Preferably, the grating layer 7 presents a high contrast index with InP. For instance, the grating layer 7 is made of a quaternary InGaAsP material having an energy gap corresponding to a photoluminescence wavelength between 1.17 and 1.4$\mu$m for a component operating in the C band around 1.55$\mu$m. The burying layer 8 is for instance made of the same material as the substrate layer 4 or the spacer layer 6, i.e. for instance InP.

The phase section 2 is made of a thick semiconductor material with a bandgap selected according to the wavelength of emission of the DFB laser 1 in use, for example having an energy gap corresponding to a photoluminescence wavelength between 1.3$\mu$m and 1.45$\mu$m. The phase section 2 has for instance a length of 100$\mu$m.

The burying layer 8 covers both Bragg sections 3 and the phase section 2.

Any adapted process may be used to fabricate a DFB laser 1, including for instance different epitaxy methods such as MBE (Molecular Beam Epitaxy), MOVPE (MetalOrganic Vapor Phase Epitaxy) or others. During the fabrication of the DFB laser 1, a mechanically or chemically etching process or any adapted method may be used for etching the phase section, etching the Bragg grating or etching the form of strip of the waveguide. For instance the DFB laser 1 fabrication process may be a Butt joint process. However others processes could be used to fabricate the DFB laser 1.

The DFB laser may be made with different structures than figure 1, for instance the DFB laser may be un-buried ridge waveguide or the DFB laser may have no grating layer 7. Instead, the teeth 9 of the Bragg grating may be etched directly in the waveguide layer 5.

Figure 2 illustrates schematically a DFB laser 100 having three sections, a phase section 200 located between two Bragg sections 300 and Figure 3 shows the tuning corresponding to emitted wavelengths when injecting current into the phase section.

The lasing peaks 10 of the DFB laser 100 are equivalent to Fabry-Perot modes of a central Fabry-Perot pseudo-cavity 11 roughly constituted by the phase section 200 length and two times the penetration depth 12 of the optical mode into both Bragg sections 300, i.e $L_{lasing}$ cavity = $L_{phase}$ + 2. $L_{penetration}$, where $L_{phase}$ is the length of the phase section 200 and $L_{penetration}$ is the penetration length of light into each Bragg section 300.

In use, the lasing peak 10 is selected by the Bragg reflectivity of the Bragg sections 3. The selected lasing peak 10 corresponds to the mode of the Fabry-Perot pseudo-cavity 11 with the wavelength closest to the maximum of Bragg reflectivity.

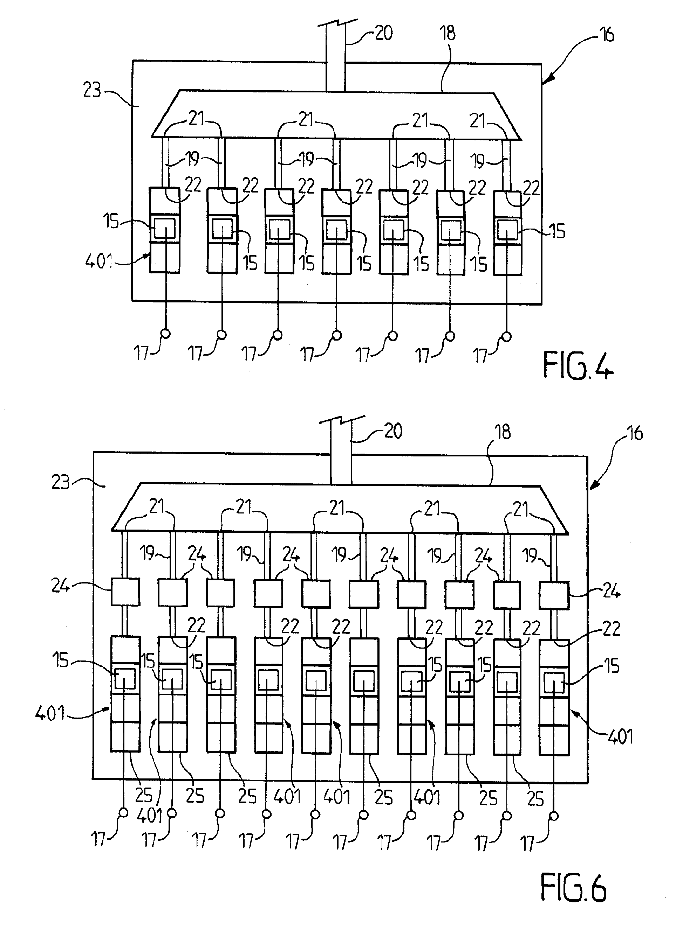

The DFB laser 100 of figure 2 is controlled by one current 13 applied in parallel to the two Bragg sections 300, and one current 14 applied to the phase section 200. When current is injected in the phase section 200, for instance using an electrode 15 (see Figure 4) connected to the phase section 200, carrier density increases. Then the index of the material decreases mainly via free carrier effect. Consequently, the phase condition is changed, leading to wavelength tuning.

As the initial phase condition is not controllable by processing, it is completely random. Consequently, the phase section 200 tuning by current injection must cover $2\pi$ to cover all the wavelengths in the tuning range capacity of the DFB laser 100. The condition that ensures that all emission wavelengths in the tuning range of the DFB laser 100 may be selected, is called the "$2\pi$ tuning condition". To fulfill the $2\pi$ tuning condition, the optical path variation must be equal to or greater than the optical path of one grating tooth. Thus, the $2\pi$ tuning condition is equivalent to :

$$\Delta_{neff\_phase}.L_{phase} \geq n_{eff\_Bragg}. \Lambda$$

where A is the grating pitch (typically ~240nm for 1.55$\mu$m emission), $L_{phase}$ is the length of the phase section 200, $n_{eff\_Bragg}$ is the effective index of the Bragg section and $\Delta_{nef\_phasef}$ is the obtainable variation of the effective index of the phase section 200 when injecting current in the phase section.

If this condition is fulfilled, then whatever the initial phase condition is, any wavelength can be selected within the tuning range.

However, this tuning range is limited by the laser stop-band, correlated to the grating strength ($\kappa$, in cm-1) and by the free spectral range of the lasing cavity, given by :

$$FSR=\lambda^2/(2 . n_{g\_phase} . L_{phase} + 2.n_{g\_Bragg}.L_{penetration})$$

Where FSR is the Free Spectral Range, $n_{g\_phasae}$ is the group index in the phase section and $n_{g\_Bragg}$ is the group index in the Bragg section.

Figure 4 illustrates a schematic representation of a photonic integrated circuit 16 including a plurality of DFB lasers according to the embodiment of figure 1.

The PIC 16 includes a plurality of DFB lasers 401 on the same semiconductor substrate 23. Each DFB laser 401 is a three sections tunable laser as analog to the DFB laser 1 described here above with reference to figure 1. Especially, each DFB laser 401 is tunable by current injection using an electrode 15. Consequently, each DFB laser 401 has its phase section 402 connected to an independent electrical power input 17. All DFB lasers 401 of the PIC 16 emit a signal at a specific wavelength defined by their specific Bragg grating pitch A, which can be finely tuned according to the current injected in its phase section 402. Each DFB laser 401 has an optical output 22.

The PIC 16 of figure 4 includes a plurality of DFB lasers 401 analog to the DFB laser 1 of figure 1. A similar PIC 16 may also be made to include DFB lasers 100 as described in figure 2.

The PIC 16 includes a multiplexer 18. The multiplexer 18 includes a plurality of inputs 21. Each input 21 of the multiplexer 18 is connected to the optical output 22 of one DFB laser 401 of the PIC 16. The multiplexer 18 receives the emitted signals 19 from all the DFB lasers 401 of the PIC 16. The multiplexer 18 combines all these signals to generate an optical output signal at the PIC output 20 for example for transmission in a single optical fiber (not shown).

PIC 16 may also include a single Peltier cooler (not shown). This Peltier cooler aims to dissipate heat from the multiplicity of DFB lasers 401 and to control the temperature of the PIC.

In the PIC 16, wavelength tuning is made by current injection in passive sections. Carrier density can reach high values, as carriers do not recombine through stimulated emission. Tuning is then much more efficient. For instance, 1nm tuning may be obtained with less than 20mA current, which corresponds to a consumption of 40mW per tunable nm.

Moreover, as the tuning of DFB lasers 401 in the PIC 16 is based on local carrier density increase and not on a DFB laser heating device, there is no thermal crosstalk between the different DFB lasers 401 of the PIC 16. As there is no thermal crosstalk, space between the different DFB lasers 401 of PIC 16 can be very short without losing tuning independency of the DFB lasers 401, providing to the PIC 16 a very small size in order to provide more devices (DFB lasers 401, multiplexer 18,...) per wafer and increase industrial yield.

The PIC may be used in semi-cooled operation. For instance Peltier temperature setting is maintained at a rather high value (typically 45°C) to limit the temperature difference between the outside environment and the Peltier temperature setting. When turning on all the lasers, their temperature reaches typically 50°C. The PIC 16, using a current injection in the phase section 402 of the DFB lasers 401 to tune emission wavelengths, advantageously maintains the lasers around 50°C, whereas tunable lasers using heating device would reach a higher temperature in those conditions, e.g. 60°C..

Figure 5 is a graphical representation of the tuning range and of the Side Mode Suppression Ratio as a function of the current injected in the phase section

With a PIC 16 of figure 4 having a plurality of DFB lasers 401, each DFB laser 401 having a $100 \mu m$ phase section 402 and a grating coupling coefficient of $50 cm^{-1}$, the $2\pi$ tuning condition is fulfilled with a current injection of 17mA in the phase section 402 and a tuning range of 0.6nm is obtained. As shown on figure 5, Side Mode Suppression Ratio (SMSR) remains greater than 35dB. Moreover, power varies by less than 1dB.

By increasing the grating coupling coefficient and using a shorter phase section with more efficient tunable material, simulations show that a tuning range up to 1.5nm can be reached.

This solution offers very low power consumption for tuning (40mW/nm). For the typical case of ten lasers, where average tuning is 0.5nm per laser, the power consumption for tuning is then reduced to 0.2W.

In addition, this power is consumed on top of the consumption of a ThermoElectric cooler (TEC) e.g. a Peltier cooler device, which is usually set to around 40-45°C (semicooled operation). Reducing the heat generated by the lasers by 1W reduces the TEC power consumption from 5.2 to 3W at 45°C, and from 7.2 to 4W at 40°C.

Power consumption is one of the main limitation for increasing the number or density of integration. With DFB lasers 401 as described above, PIC 16 may include more devices than known PIC or, for the same number of devices, may have lower power consumption. Moreover, for these applications, power homogeneity is typically specified to be less than 2dB which can be reached by a PIC 16 as described above, in which power variation with tuning remains below 1dB.

Another critical aspect of PICs is the industrial yield, and the reliability. Operating lasers at a temperature close to the TEC setting highly reduces reliability risks. For a 45°C TEC temperature set point, laser operation temperature is typically 50°C due to self-heating by current injection.

Figure 6 illustrates a schematic representation of another embodiment of a photonic integrated circuit.

The PIC 16 in this embodiment is similar to the PIC 16 of figure 4. In fact, the PIC 16 illustrated in figure 6 includes, grown on the same substrate 23, a plurality of three-sections DFB lasers 401, each DFB laser 401 being independently tunable by current injection using an electrode 15 connected to an independent electrical power input 17. The PIC 16 also includes a multiplexer 18 which combines the signals received from the DFB lasers 401 to generate the optical output signal of the PIC. The PIC 16 may also include a single Peltier cooler (not shown).

However, the PIC 16 illustrated in figure 6 also includes a plurality of modulators 24. Each modulator 24 is located between the optical output 22 of one DFB laser 401 and the corresponding optical input 21 of the multiplexer 18. For instance, such a modulator 24 may be a Mach-Zehnder modulator or an electro-absorption modulator. This embodiment enables to generate quadrature phase-shift keying (QPSK) modulation, for instance using two Mach-Zehnder modulators in parallel.

The PIC 16 illustrated in figure 6 also includes a plurality of photodiodes 25. Each photodiode 25 is coupled with one DFB laser 401. DFB lasers 401 and their coupled photodiodes 25 are grown on the same substrate 404, the photodiode 25 being placed at a rear extremity of the DFB laser 401 opposed to the optical output 22 of said DFB laser 401. The photodiodes 25 may be made with the same material as the Bragg sections 403 but without grating, and with a reverse bias. The photocurrent is a direct measurement of the back side output power, which can be used to monitor output power, or in feedback loops including power dithering of the DFB laser 401.

The invention is not limited to the described embodiments. The appended claims are to be construed as embodying all modification and alternative constructions that may be occurred to one skilled in the art, which fairly fall within the basic teaching here, set forth.

The use of the verb "to comprise" or "to include" and its conjugations does not exclude the presence of elements or steps other than those stated in a claim. Furthermore, the use of the article "a" or "an" preceding an element or step does not exclude the presence of a plurality of such elements or steps.

In the claims, any reference signs placed between parentheses shall not be construed as limiting the scope of the claims.

## Claims

1. A photonic integrated circuit PIC (16) comprising a semiconductor substrate layer and a plurality of Distributed FeedBack lasers, hereafter named DFB lasers (1, 100, 401), arranged on the semiconductor substrate layer, each DFB laser having a tuning device able to tune its output wavelength, wherein each DFB laser of the PIC has a phase section (2, 402) in passive material longitudinally located between two Bragg sections (3, 403) in active material, each Bragg section comprising a waveguide (5) in the form of an elongate strip and a Bragg grating including a plurality of grating teeth mutually spaced by a grating pitch that extends along a longitudinal direction of the Bragg section, and wherein the tuning device of each DFB laser includes an electrode (15) arranged on the phase section of said DFB laser, the electrode being connected to an electrical source for applying an electrical signal to the phase section, the electrode being able to inject current in the phase section of the DFB laser to tune the emission wavelength of said DFB laser, and wherein the current injection by the electrode in the phase section causes an optical path variation in the phase section and wherein the amplitude of the optical path variation in the phase section is at least equal to or greater than the optical path of one grating pitch of the Bragg grating.

2. A photonic integrated circuit according to claim 1, further including a multiplexer (18) arranged on the semiconductor substrate layer and having a plurality of inputs (21) wherein each DFB laser of the plurality of DFB lasers of the PIC has an optical output (22) which is connected to a respective input of the multiplexer.

3. A photonic integrated circuit according to claim 2, further including a waveguide between the optical output of each DFB laser and the corresponding input of the multiplexer, the waveguide being arranged on the semiconductor substrate layer.

4. A photonic integrated circuit according to anyone of claims 1 to 3, further including a ThermoElectric Cooler arranged on the semiconductor substrate layer.

5. A photonic integrated circuit according to anyone of claims 1 to 4, wherein each Bragg section is connected to an electrode, said electrode being connected to an electrical source for applying an electrical signal to said Bragg section.

6. A photonic integrated circuit according to anyone of claims 1 to 5, including a plurality of modulators, wherein each modulator is connected to one DFB laser to receive a DFB laser output signal to modulate.

7. A photonic integrated circuit according to anyone of claims 1 to 6, including a plurality of photodiodes, and wherein each photodiode is located at an end of a DFB laser.

8. A photonic integrated circuit according to claim 7, wherein the plurality of photodiodes are in the same material than the Bragg sections with a reverse bias.

9. An optical communication terminal including a photonic integrated Circuit according to anyone of claims 1 to 8.

FIG.1

FIG.3

FIG.2

FIG.5

EP 2 894 734 A1

FIG.4

FIG.6

Europäisches
Patentamt

European
Patent Office

Office européen
des brevets

# EUROPEAN SEARCH REPORT

Application Number

EP 14 30 5050

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | RADHAKRISHNAN NAGARAJAN ET AL: "Large-Scale Photonic Integrated Circuits", IEEE JOURNAL OF SELECTED TOPICS IN QUANTUM ELECTRONICS, IEEE SERVICE CENTER, PISCATAWAY, NJ, US, vol. 11, no. 1, 1 January 2005 (2005-01-01), pages 50-65, XP007914724, ISSN: 1077-260X, DOI: 10.1109/JSTQE.2004.841721 [retrieved on 2005-02-22] * abstract; figure 1 * * page 50, right-hand column * * page 51 * * pages 52-53 * * page 54, left-hand column * ----- | 1-4,6-9 | INV. H01S5/0625 H01S5/40 H01S5/026 ADD. G02B6/12 H04J14/02 H04B10/50 |
| Y | YASAKA H ET AL: "Optical frequency spacing tunable four-channel integrated 1.55 mu m multielectrode distributed-feedback laser array", IEEE PHOTONICS TECHNOLOGY LETTERS, IEEE SERVICE CENTER, PISCATAWAY, NJ, US, vol. 1, no. 4, 1 April 1989 (1989-04-01), pages 75-76, XP011407375, ISSN: 1041-1135, DOI: 10.1109/68.87907 * abstract; figure 1 * * page 75, left-hand column * * page 76, right-hand column * ----- | 1 | TECHNICAL FIELDS SEARCHED (IPC) H01S H04B H04J G02B |

-/--

The present search report has been drawn up for all claims

| Place of search | Date of completion of the search | Examiner |
|---|---|---|
| Munich | 24 April 2014 | Gnugesser, Hermann |

**EUROPEAN SEARCH REPORT**

Application Number

EP 14 30 5050

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | FANG W ET AL: "An Integrated Four-channel Tunable Distributed-feedback Laser Array", CLEO '97: CONFERENCE ON LASERS AND ELECTRO-OPTICS. BALTIMORE,MD, MAY 18 - 23, 1997; [CLEO : CONFERENCE ON LASERS AND ELECTRO-OPTICS], NEW YORK, IEEE, US, vol. 11, 18 May 1997 (1997-05-18), pages 28-29, XP010232775, ISBN: 978-0-7803-4125-8 * page 29, left-hand column * | 1,2 | |
| Y | US 2002/064203 A1 (PEZESHKI BARDIA [US] ET AL) 30 May 2002 (2002-05-30) * paragraphs [0002], [0030] - [0033], [0040] - [0042]; figure 2 * | 1,5 | |
| Y | TAKAHIRO NUMAI: "1.5-UM WAVELENGTH TUNABLE PHASE-SHIFT-CONTROLLED DISTRIBUTED FEEDBACK LASER", JOURNAL OF LIGHTWAVE TECHNOLOGY, IEEE SERVICE CENTER, NEW YORK, NY, US, vol. 10, no. 2, 1 February 1992 (1992-02-01), pages 199-205, XP000267491, ISSN: 0733-8724, DOI: 10.1109/50.120575 * abstract; figures 1,5, 6 * * page 202 * | 1,5 | TECHNICAL FIELDS SEARCHED (IPC) |
| Y | US 2008/044128 A1 (KISH FRED A JR [US] ET AL) 21 February 2008 (2008-02-21) * paragraphs [0003], [0074], [0080], [0083], [0130] - [0132], [0135], [0148], [0157] - [0159], [0188]; figures 11-16, 19A, 20, 33,34 * | 1-4,6-9 | |

-/--

The present search report has been drawn up for all claims

| Place of search | Date of completion of the search | Examiner |
|---|---|---|
| Munich | 24 April 2014 | Gnugesser, Hermann |

EPO FORM 1503 03.82 (P04C01)

Europäisches
Patentamt

European
Patent Office

Office européen
des brevets

## EUROPEAN SEARCH REPORT

Application Number

EP 14 30 5050

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | SARTORIUS B ET AL: "All-optical clock recovery module based on self-pulsating DFB laser", ELECTRONICS LETTERS, IEE STEVENAGE, GB, vol. 34, no. 17, 20 August 1998 (1998-08-20), pages 1664-1665, XP006010192, ISSN: 0013-5194, DOI: 10.1049/EL:19981152 * abstract; figure 1 * ----- | 1,4,5 | |

TECHNICAL FIELDS
SEARCHED (IPC)

The present search report has been drawn up for all claims

| Place of search | Date of completion of the search | Examiner |
|---|---|---|
| Munich | 24 April 2014 | Gnugesser, Hermann |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

&: member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 14 30 5050

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2014

| Patent document cited in search report | Publication date | Patent family member(s) | Publication date |
|---|---|---|---|
| US 2002064203 A1 | 30-05-2002 | NONE | |
| US 2008044128 A1 | 21-02-2008 | NONE | |

EPO FORM P0459

For more details about this annex : see Official Journal of the European Patent Office, No. 12/82